# EUROPEAN PATENT SPECIFICATION

(11) **EP 0 731 417 B1**
(45) Date of publication and mention of the grant of the patent: **14.07.2004**
(21) Application number: 96301314.9
(22) Date of filing: 27.02.1996
(51) Int. Cl.: G06K 7/10, H01S 5/10, H01S 5/40

(54) **Scan module for optical scanner**
Abtastmodul für einen optischen Abtaster
Module de balayage pour balayeur optique

(30) Priority: 27.02.1995 US 394813
(43) Date of publication of application: 11.09.1996
(73) Proprietor: SYMBOL TECHNOLOGIES, INC., Bohemia New York 11716 (US)
(72) Inventor: Stern, Miklos, Flushing, New York,11367, (US); Katz, Joseph, New York 11790, (US); Campanelli, Joseph, New York 11790, (US); Dvorkis, Paul, New York 11790, (US); Metlitsky, Boris, New York 11790, (US); Gurevich, Vladimir Yuri, New York,117799, (US); Krichever, Mark, New York 11788, (US); McGlynn, Daniel R, New York 11209, (US)
(74) Representative: Hibbert, Juliet Jane Grace

(56) References cited:
- EP-A- 0 459 025
- EP-A- 0 460 684
- WO-A-94/19765
- US-A- 5 258 605
- US-A- 5 266 787
- US-A- 5 315 095
- US-A- 5 359 669
- US-A- 5 525 810

## Description

The invention relates to optical scanners and in particular to a novel miniature scan engine/module for such scanners, preferably but not necessarily using wafer technology and incorporating a vertical cavity surface emitting laser diode (VCSEL). The invention further extends, more generally to an integrated optical module using VCSEL technology.

Various optical readers and optical scanning systems have been developed heretofore for reading indicia such as bar code symbols appearing on a label or on the surface of an article. The bar code symbol itself is a coded pattern of indicia comprised of a series of bars of various widths spaced apart from one another to bound spaces of various widths, the bars and spaces having different light reflecting characteristics. The readers in scanning systems electro-optically transform the graphic indicia into electrical signals, which are decoded into alphanumeric characters that are intended to be descriptive of the article or some characteristic thereof. Such characteristics are typically represented in digital form and utilized as an input to a data processing system for applications in point-of-sale processing, inventory control and the like. Scanning systems of this general type have been disclosed, for example, in U.S. Patents US-A-4,251,798; US-A 4,369,361; US-A-4,387,297; US-A-4,409,470; US-A-4,760,428; and US-A-4,896,026. As disclosed in some of the above patents, one embodiment of such a scanning system resides, inter alia, in a hand held, portable laser scanning device supported by a user, which is configured to allow the user to aim the scanning head of the device, and more particularly, a light beam, at a targeted symbol to be read.

The light source in a laser scanner bar code reader is typically a gas laser or semiconductor laser. The use of semiconductor devices as the light source is especially desirable because of their small size, low cost and low voltage requirements. The laser beam is optically modified, typically by an optical assembly, to form a beam spot of a certain size at the target distance. It is preferred that the cross section of the beam spot at the target distance be approximately the same as the minimum width between regions of different light reflectivity, i.e., the bars and spaces of the symbol. At least one bar code reader has been proposed with two light sources to produce two light beams of different frequency.

One laser-based bar code scanner relevant to the present invention is disclosed in U.S. Patent US-A-5,144,120 to Krichever et al. which employs laser, optical and sensor components in conjunction with a so-called "mirrorless" scanner arrangement. One or more of these components are mounted on a drive for repetitive reciprocating motion either about an axis or in a plane to effect scanning.

Another proposed bar code scanner employs electronic means for causing the light beam to scan a bar code symbol, rather than using a mechanical device. A linear array of light sources activated one at a time in a regular sequence may be imaged upon the bar code symbol to simulate a scanned beam. Instead of a single linear array of light sources, a multiple-line array may be employed, producing multiple scan lines. Such a scanner is disclosed in U.S. Patent US-A-5,258,605.

Typically, the semiconductor lasers used in such bar code scanners is an edge-emitting injection laser in which the laser beam is emitted from the p-n junction region on a polished end face of the device.

By their physical nature, these known edge-emitting injection lasers emit a beam from a thin region at the p-n junction. A laser beam emanating from a thin source has a large beam divergence which makes focusing difficult and results in a wide range of variability in performance from laser to laser.

A more recently developed form of semiconductor laser is the vertical-cavity surface-emitting laser diode (VCSEL), such as described in "Efficient Room-Temperature Continuous-Wave AlGaInP/AlGaAs Visible (670 nm) Vertical-Cavity Surface Emitting Laser Diodes" by R P Schneider et al. published in IEEE Photonics Technology Letters, Vol. 6, No. 3, March 1994. Reference is also made to U.S. patents US-A-5,283,447; US-A-5,285,455; US-A-5,266,794; US-A-5,319,496; and US-A-5,326,386, for background information.

The VCSEL has a substantial surface area from which the laser beam is emitted; this area may be patterned. Thus, the beam produced is less divergent in one dimension than with known edge-emitting type semiconductor laser diodes. The output beam is round, and is virtually not astigmatic. Furthermore, VCSELs typically operate at significantly lower currents than edge-emitting laser diodes. Therefore, it also generates less heat.

In the laser beam scanning systems known in the art, a single laser light beam is directed by a lens or other optical components along the light path toward a target that includes a bar code symbol on the surface. The moving-beam scanner operates by repetitively scanning the light beam in a line or series of lines across the symbol by means of motion or a scanning component, such as the light source itself or a mirror disposed in the path of the light beam. The scanning component may either sweep the beam spot across the symbol and trace a scan line across the pattern of the symbol, or scan the field of view of the scanner, or do both.

US patent no. US-A-5266787 reflecting the preamble of claim 1 describes a laser scanner having two scan motors independently controlled by a single signal. A dual motor speed control circuit for providing independent speed control of two motors in a laser scanning device is disclosed, which uses a single input signal having variable frequency and duty cycle components. The speed of the first motor is controlled by using the frequency component of the input signal while the speed of the second motor is controlled by using the frequency and duty cycle components of the input signal. Specifically, a DC signal is generated that is dependent upon the duty cycle component of the input signal and the DC signal is used to offset the speed of the second motor from the speed value as determined by the frequency component of said input signal.

European patent application no. EP-A-0460684 relates to optical information reading apparatus such as a barcode reader. The apparatus includes a mirror drive unit rotatable to oscillate a moveable scanning mirror simultaneously about a first axis and a second axis perpendicular to the first axis so that a laser beam irradiated from a laser unit is directed by the movable scanning mirror vertically and horizontally to scan parallel arranged plural rows bar codes with a raster scanning pattern.

Bar code reading systems also include a sensor or photodetector which detects light reflected or scattered from the symbol. The photodetector or sensor is positioned in the scanner in an optical path so that it has a field of view which ensures the capture of a portion of the light which is reflected or scattered off the symbol, detected, and converted into an electrical signal. Electronic circuitry and software decode the electrical signal into a digital representation of the data represented by the symbol that has been scanned. For example, the analog electrical signal generated by the photodetector is converted by a digitizer into a pulse or modulated digitized signal, with the widths corresponding to the physical widths of the bars and spaces. Such a digitized signal is then decoded, based on the specific symbology used by the symbol, into a binary representation of the data encoded in the symbol, and subsequently to the alpha numeric characters so represented.

The decoding process of known bar code reading system usually works in the following way. The decoder receives the pulse width modulated digitized signal from the digitizer, and an algorithm, implemented in the software, attempts to decode the scan. If the start and stop characters and the characters between them in the scan were decoded successfully and completely, the decoding process terminates and an indicator of a successful read (such as a green light and/or an audible beep) is provided to the user. Otherwise, the decoder receives the next scan, performs another decode attempt on that scan, and so on, until a completely decoded scan is achieved or no more scans are available.

Such a signal is then decoded according to the specific symbology into a binary representation of the data encoded in the symbol, and to the alphanumeric characters so represented.

Moving-beam laser scanners are not the only type of optical instruments capable of reading bar code symbols. Another type of bar code reader is one which incorporates detectors based on solid state imaging arrays or charge coupled device (CCD) technology. In such prior art readers the sides of the detector are typically smaller than the symbol to be read because of the image reduction by the objective lens in front of the array or CCD. The entire symbol is flooded with light from a light source such as lighting light emitting diodes (LED) in the scanning device, and each cell in the array is sequentially read out to determine the presence of a bar or a space in the field of view of that cell.

The working range of CCD bar code scanners is rather limited as compared to laser-based scanners and is especially low for CCD based scanners with an LED illumination source. Other features of CCD based bar code scanners are set out in U.S. Patent US-A-5,396,054, and in U.S. Patent US-A-5,210,398. These references are illustrative of the certain technological techniques proposed for use in CCD type scanners to acquire and read indicia in which information is arranged in a two dimensional pattern.

It is a general object of the invention to provide a laser scanner for bar code reading implemented on a semiconductor substrate.

It is another object of the present invention to mount light emitting and detecting elements on a miniature frame assembly capable of motion for effecting a scanning pattern.

It is still another object of the present invention to provide an array of lenses and/or an array of liquid crystal shutter elements adjacent to a semiconductor substrate that includes an array of light emitting and/or detecting elements.

It is yet another object of the present invention to provide an illumination light source for a bar code reader using a vertical cavity surface emitting laser diode.

It is still another object to enable auto alignment (i.e., do away with the focusing step in a manufacturing process) by using VCSEL arrays to achieve multiple focus.

It is yet a further object of the present invention to provide an integrated optical module, preferably although not necessarily for use within an optical scanner, which is not only robust in use but which can be manufactured in large quantities relatively inexpensively.

In accordance with these objects, the invention extends to an integrated optical module having a VCSEL which is spaced from a refractive or diffractive lens by a spacer of predetermined dimensions. During manufacture, the dimensions of the spacer may be chosen so that the laser beam is appropriately focused by the lens according to the desired application.

Such-modules may conveniently be manufactured using wafer-scale, processing and assembly technology. Using this approach, a wafer array of spacers is bonded within a sandwich formed by a wafer array of lenses on one side and a wafer array of VCSELs on a substrate on the other. Once the sandwich has been bonded or otherwise secured together, it may be cut up or diced into the required modules. Prior to dicing, the VCSELs making up the array on the substrate may be individually tested. Another approach is to dice the VCSELs initially, and then flip-chip mount them on the optical substrate. Electrical contacts can be established via solder bumps.

The sandwich may be diced into individual modules, each containing exactly one VCSEL, or it may be diced into larger units, each including a plurality of VCSELs in an array, for example for redundancy, multiple-ranging, time multiplexing, additional power or beam shaping.

It is a further object of the invention to provide a miniaturized scan engine or module for an optical scanner that is small, robust, and relatively inexpensive. It is a further object to provide a scan engine in which the current required for operation is reduced.

The general concept of the present invention, in one arrangement, comprises a scan engine, module or micro-mirror package in a sandwich structure consisting of a top cap, a bottom substrate, and a mirror in between. The scan engine may be manufactured in a batch process, for instance by micro-machining. The top cap and bottom substrate contain features to limit mirror travel so that the mirror hinges are protected against impact. To facilitate assembly, the sandwich may be laminated on the wafer scale, and then diced into individual cells. Electrodes and access means are provided both to actuate the mirror and to sense the mirror position. In addition, in some embodiments. a transparent cover is provided to protect the mirror, with clear electrodes either for electrostatic actuation of the mirror or for use in detecting mirror position. To minimise overall package height, thin wafers are used.

Each of the wafers is made of an appropriate material, such as plastics or silicon for the upper and lower wafers and silicon for the central wafer. Metal portions are added by printing, coating, or any other convenient means. For large scale manufacture, micromachining, microinjection moulding, compression-injection moulding and stamping are likely to be the most cost effective processes. The general approach described in Borgesen et al, Materials Research Society Symposium Proceedings, Vol. 323, 1994, may be used.

The lens wafer may be omitted, in some embodiments, with focusing of the VCSELs being provided by a suitable shaping (for example by etching or electron beam writing) of the VCSEL aperture itself, or of the mirror surface.

The invention also relates to a scan engine in which the mirror is actuated using the shape memory effect, for example in TiNi hinges. The amount of current needed to heat the hinges is reduced by providing an electrically conductive coating on those portions of the hinges which do not substantially contribute to the movement. Typically, this means coating a central portion of each hinge with a conductive coating, and leaving the end portions uncoated. The mirror may also be actuated (particularly but not exclusively in a cantilever arrangement) by applying heat to a bimetallic beam, or by electrostatic control. Piezo-electric control is also a possibility.

In keeping with the previously-stated objects, and others which will become apparent hereinafter, in one embodiment of the invention there is provided an integrated electro-optical system for reading indicia having parts of different light reflectivity, e.g. bar code symbols having alternating bars and spaces.

In one preferred embodiment, there is provided a method of reading indicia such as a bar code symbol by illuminating a field containing the indicia with a sequence of light spots by sequentially activating a plurality of separate light sources which are disposed on a semiconductor substrate; and detecting light reflected from the field to produce an electrical signal representing light of variable intensity reflected off the indicia.

Preferably, a bar code reader for reading such indicia includes a light source component for emitting one or more light beams; a light directing component for directing the light beam along a path toward the indicia; and a stationary photodetector component having a field of view and operative for detecting at least a portion of the light of variable intensity reflected off the indicia. An optical arrangement may be provided which functions to provide a series of independent scans of the indicia, each scan representing a different focal plane disposed exteriorly to the reader.

Preferably, a laser scanning device comprises a vertical-cavity, surface-emitting laser, mounted on a substrate and arranged to produce a multiple laser beam output, a scanning arrangement for effecting scanning by the laser beam, an optical arrangement for focusing the output on a target to be scanned, and a sensor for detecting the reflected light from the target.

The surface area of a VCSEL may usefully be used to support an optical component, such as a diffractive or refractive lens, directly in front of the diode surface. Mounting of the optical component may conveniently be effected during fabrication to achieve desired focusing. The laser may be operated only for short bursts in scanner applications, further reducing the power consumption of the VCSEL. As a result, the substrate for the VCSEL is likely to provide sufficient heat dissipation such that further head sinking of the laser is not required.

In one particular embodiment of the invention, a phased array of lasers may be arranged in groups that define focused scanning beams at differing positions. Alternatively, scanning may be done electronically by actuating a phased array of laser diodes to create the effect of a single scanning beam. These may be actuated selectively or in a predetermined automatic sequence. Thus, a multi-line scan may be produced, or the beam for two or more lasers may be developed to produce a beam spot of a given shape on a predetermined target plane, if that is the system requirement.

Scanning may also be effected by physically moving the laser about a field point or points. In both cases, therefore, especially in that of the phased array of lasers, the lower power consumption of the VCSEL is advantageous over prior art devices.

As used in this specification and the following claims, the term "symbol" is intended to be broadly construed and to cover not only symbol patterns composed of alternating bars and spaces, but also other patterns, as well as alphanumeric characters and, in short, any indicia having portions of different light reflectivity.

The invention may be carried into practice in a number of ways and several specific embodiments will now be described, by way of example, with reference to the accompanying drawings, in which:
Figure 1 shows a two-dimensional scanner according to an embodiment of the invention using two micromachined mirrors;
Figure 2 shows another embodiment using only one micromachined mirror but with an array of VCSELS that are turned on and off in a time-multiplexed manner;
Figure 3 shows another embodiment including an array of individual small mirrors;
Figure 4A shows yet another embodiment using two mirrors which are mounted on the same substrate but which scan in orthogonal directions; and
Figure 4B shows yet another embodiment.

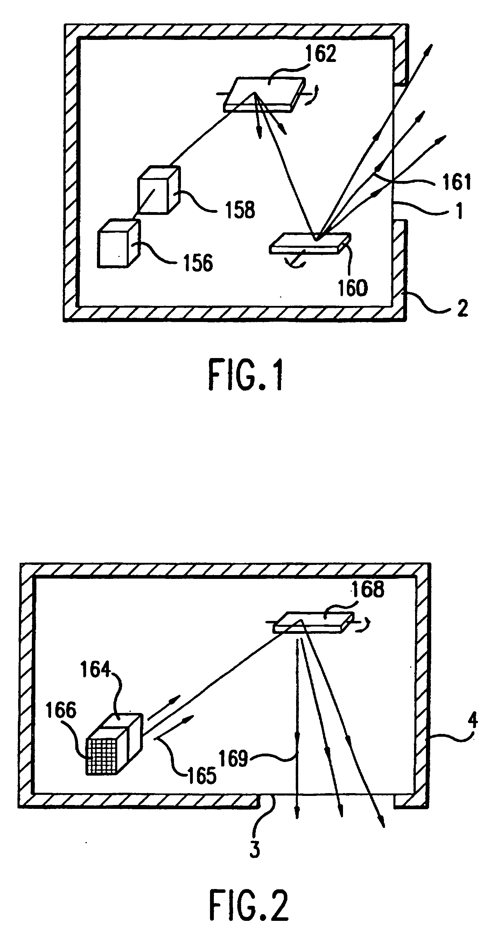

Figures 1 to 4 show, in highly simplified and schematic form, some embodiments of scan engines/modules in accordance with the present invention. The modules shown are general purpose optical scanning modules which are suitable for a number of applications including, for example, bar code readers.

In Figure 1, light from a VCSEL (vertical cavity surface emitting laser diode) 156 is shaped and deflected by a refractive and/or diffractive optical element (DOE) 158. The DOE combines the functions of focusing, beam direction bending and some aberration or scan beam quality correction. The beam is then directed to a first mirror 162, scanning in the y direction, and then a second mirror 160, scanning in the x direction, to produce a two-dimensional scanning beam 161 which is directed via a window 1 in a housing 2 to an indicia (not shown) to be read. Reflected light from the indicia is detected by a photodetector (not shown) and digitized/decoded to interpret the indicia.

The order of the mirrors can be reversed, i.e. the first may scan in the x-direction and the second in the y-direction. Alternatively, a single 2D mirror can be used; 2D scanning may also be accomplished by a single cantilever structure.

Figure 2 shows a VCSEL array 166 and, in front of it, a DOE array 164. The VCSELs are turned on and off in a time multiplexed manner, thereby creating a beam 165 (or more properly a series of beams) which scans in the y direction. These beams are then incident upon an oscillating mirror 168, scanning in the x direction, to provide a two-dimensional scanning beam 169. This leaves a scanner housing 4 via a window 3 in a direction towards an indicia (not shown) to be scanned. Alternatively, reference numeral 166 may represent a laser array, and 164 an optical element and switching array. In this alternative, the laser array 166 is left on at all times, with the switching array 164 determining which beam or parts of the beam are allowed to pass. The switching array is sequentially actuated so that each optical element in the array in turn bends and/or focuses the beam. Since each optical element bends and/or focuses to a different extent, the resultant composite effect is of a single beam which scans in one direction.

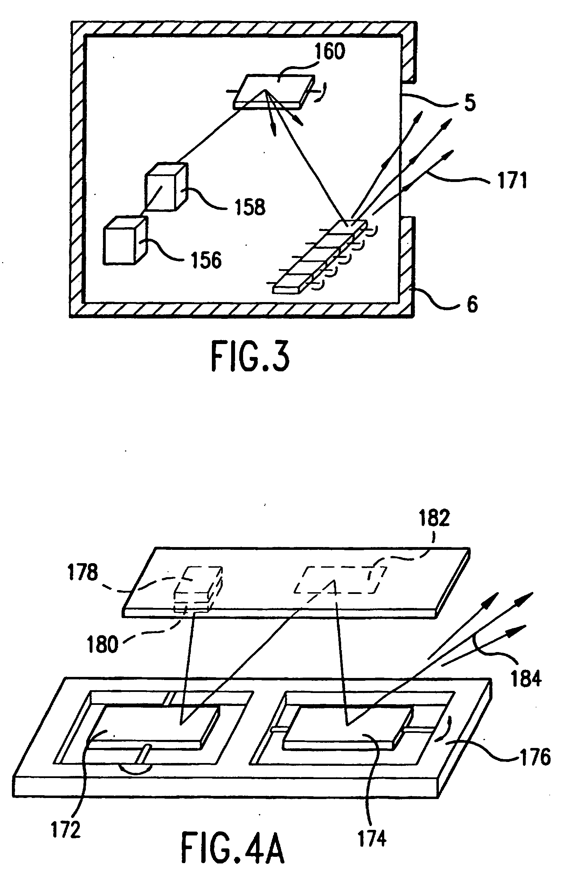

Figure 3 corresponds generally to Figure 1, except that the second oscillating mirror 160 is replaced by an array 170 of smaller mirrors or "micro-mirrorlets". These smaller mirrorlets each scan in the same x direction, but are timed to be synchronous with the y scanning direction provided by the mirror 160. The advantage of smaller mirrors is higher frequency and possibly lower drive power. Again, the result is a beam 171 which scans in two dimensions. As before, the beam 171 leaves a scanner housing 6 via a window 5 towards an indicia (not shown) to be scanned.

Figure 4A shows yet another embodiment using two mirrors 172,174 mounted on a common substrate 176, but scanning in orthogonal directions. Light from a VCSEL 178 passes through a DOE 180 and is incident upon the first mirror 172. It is then reflected to a folding mirror 182 and back to the second mirror 174 to provide a two-dimensionally scanning outgoing beam 184. By mounting both mirrors 172 and 174 onto a common substrate, alignment problems may be reduced.

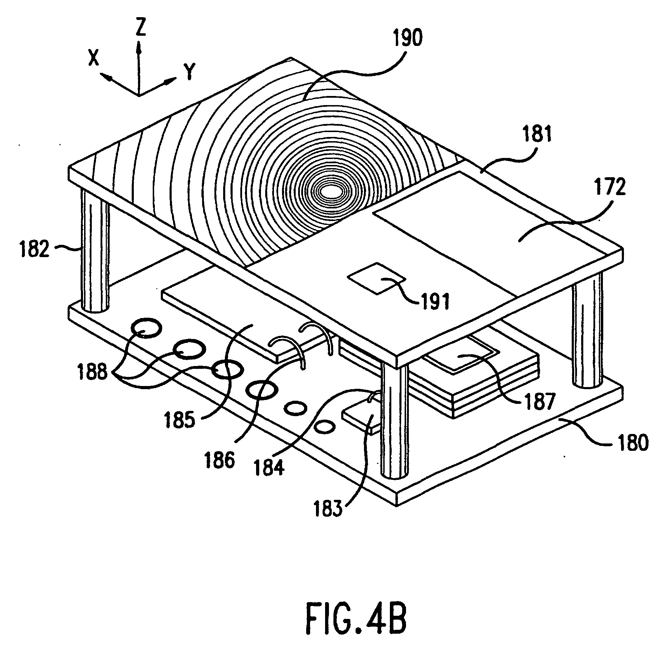

Figure 4B shows a practical embodiment of some of the ideas previously mentioned in connection with Figures 1 to 4A. The scanner assembly shown in Figure 4B has ceramic or plastic lower and upper substrates 180, 181, the distance between them being defined by spacers 182. Mounted on the lower substrate 180 is a VCSEL 183 with leads 184, a detector 185 with leads 186, a lower mirror 187, and interconnect pads 188. The upper substrate 181 includes collector optics 190, an upper downwardly-directed mirror 191 and a window 192 through which the outgoing scan beam passes. The electrical interconnect pads 188 provide electrical connections through the leads 184 to the VCSEL and through the leads 186 to the detector. Electrical control leads (not shown) are also provided to the lower mirror 187 and to the upper mirror 191. In operation, the VCSEL 183 produces a laser beam (not shown) which is directed onto the upper mirror 191. This is mounted for oscillation as discussed in Figures 1 to 3 so that the reflected beam scans in the x direction. The reflected scanning beam then impinges upon the lower mirror 187, which is mounted for scanning motion in the y direction. The resulting beam, scanning in both directions, passes out of the module through the window 192 towards an indicia (not shown) to be scanned. Light reflected from the indicia is collected by the collector optics 190 and is detected by the detector 185. The electrical output produced by the detector passes through the lines 186 to the interconnect pads 188 from which the signal may be passed on to a digitiser and if necessary to a decoder.

In all of the embodiments of Figures 1 to 4, the DOE may if desired be replaced by a holographic optical element or a micro-refractive optical element.

It is not essential for the mirror to be suspended between torsional hinges, as previously described. Other modes of mounting the mirror for oscillation may be equally useful, and all are intended to be encompassed within the scope of the present invention.
The mirror may be oscillated by an convenient means, including electromagnetically, electrostatically, bimetallically, or by means of the shape memory process. The mirror is desirably rectangular, but could also be square, circular or elliptical. Laser speckle may be reduced by the use of several lasers.

The present invention relates not only to one-dimensional but also to two-dimensional scanners.

Of course, the present invention can be made to work equally well with light emitted at wavelengths in the visible or in the infra-red range.

In a CCD reader, for example, employing an optical bandpass filter before the detector can reduce the ambient light reaching the detector. The combination of the filter and the high power output from the lasers (resulting in very good target illumination) can significantly increase the working range of such detectors, which is especially important for imaging types of detectors.

Although the present invention has been described in at least some embodiments with respect to reading one or two dimensional bar codes and other indicia, it is not limited to such embodiments, but may also be applicable to more complex indicia scanning applications. It is conceivable that the present invention may also find application for use with various machine vision or optical character recognition applications in which information is derived from other types of indicia such as characters or from the surface characteristics of the article being scanned. It may also find application in pen-scanners, mice, telephone scanners, PC-cards and so on.

In all of the various embodiments, the elements of the scan engine may be assembled into a very compact package that allows the entire scanner to be fabricated as a micro-module. Such a module can interchangeably be used as the laser scanning element for a variety of different types of data acquisition systems. For example, the module may be alternately used in a hand-held scanner, a table top scanner attached to a flexible arm or mounting extending over the surface of the table or attached to the underside of the table top, or mounted as a subcomponent or subassembly of a more sophisticated data acquisition system. Control or data lines associated with such components may be connected to an electrical connector mounted on the edge or external surface of the module to enable the module to be electrically connected to a mating connector associated with other elements of data acquisition system.

An individual module may have specific scanning or decoding characteristics associated with it, e.g. operability at a certain working distance, or operability with a specific symbology or printing density. The characteristics may also be defined through the manual setting of control switches associated with the module. The user may also adapt the data acquisition system to scan different types of articles or the system may be adapted for different applications by interchanging modules on the data acquisition system through the use of the simple electrical connector.

The scanning module described above may also be implemented within a self-contained data acquisition system including one or more such components as keyboard, display, printer, data storage, application software, and data bases. Such a system may also include a communications interface to permit the data acquisition system to communicate with other components of a local area network or with the telephone exchange network, either through a modem or an ISDN interface, or by lower power radio broadcast from the portable terminal to a stationary receiver.

It will be understood that each of the features described above, or two or more together, may find a useful application in other types of scanners and bar code readers differing from the types described above. It is specifically contemplated by the applicants that any one or more of the features described or referred to above may form part of the present invention. It is further contemplated that any two or more compatible features, taken together, may also form part of the present invention. Accordingly, it should be understood that, where applicable, features referred to and described in connection with one figure may be used in association with features described in connection with another figure

## Claims

1. An optical reader having a light source for emitting a light beam (184) along an optical path to coded indicia to be optically read, and a scanner for sweeping the light beam (184) in mutually orthogonal directions across the coded indicia, the optical reader comprising:
a) a common support (176; 180, 181); and
b) the scanner having a first oscillatable mirror (172, 191) mounted on the support for oscillation relative thereto to sweep the beam (184) in one of the directions when oscillated, and a second oscillatable mirror (174; 187) mounted on the support for oscillation relative thereto to sweep the beam reflected from the first oscillattable mirror (172; 191) in the other of the directions when oscillated, said mirrors (172, 174; 187, 191) being arranged on the support in mutual optical alignment along the optical path due to their mountings at fixed positions on the support; **characterized in that**:
the common support is a planar, base substrate (176) having first and second openings extending there through, and wherein the first and second mirrors (172, 174) are at least partly received in the first and second openings, respectively.

2. The optical reader of claim 1, wherein each opening is a rectangular cutout, and wherein each of the first and second mirrors (172, 174) is a rectangular, planar mirror.

3. The optical reader of claim 1, wherein the support includes a second planar, base substrate on which a stationary folding mirror ( 182) is supported, and wherein the stationary mirror (182) is located along the optical path between the first and second mirrors (172, 174).

4. The optical reader of claim 3, wherein the light source is a vertical cavity surface emitting laser diode (178) for emitting the light beam as a single laser beam.

5. The optical reader of claim 3, wherein the light source is an array of vertical cavity surface emitting laser diodes (166) for emitting the light beam as a plurality of laser beams.

6. The optical reader of claim 4, further comprising an optical element (180) for focusing and deflecting the laser beam.

7. The optical reader of claim 5, further comprising a switchable array (164) of optical elements for focusing and deflecting each laser beam.

8. The optical reader of claim 1, further comprising a housing (2, 4) having a window (1, 3) through which the light beam passes en route to the indicia.

## Patentansprüche

1. Ein optischer Leser mit einer Lichtquelle zum Emittieren eines Lichtstrahls (184) entlang eines optischen Pfads zu codierten (Kenn-) Zeichen, die optisch zu lesen sind, und mit einem Scanner zum Streichen des Lichtstrahls (184) in gegenseitig orthogonalen Richtungen über die codierten (Kenn-)Zeichen hinweg, wobei der optische Leser Folgendes aufweist:
a) einen gemeinsamen Träger (176; 180, 181); und
b) wobei der Scanner einen ersten schwingbaren Spiegel (172, 191), der auf dem Träger angebracht ist zur Schwingung relativ dazu, um den Strahl (184) in eine der Richtungen zu streichen, wenn er geschwungen wird, sowie einen zweiten schwingbaren Spiegel (174; 187) aufweist, der auf dem Träger angebracht ist zur Schwingung relativ dazu, um den von dem ersten schwingbaren Spiegel (172; 191) reflektierten Strahl in die andere der Richtungen zu streichen, wenn er geschwungen wird, wobei die Spiegel (172, 174; 187, 191) in gegenseitiger optischer Ausrichtung entlang des optischen Pfads auf dem Träger angeordnet sind aufgrund ihrer Befestigungen an festen Positionen auf dem Träger; **dadurch gekennzeichnet dass**:
der gemeinsame Träger ein planares Basissubstrat (176) ist mit ersten und zweiten Öffnungen, die sich dahindurch erstrecken, und wobei die ersten und zweiten Spiegel (172, 174) zumindest teilweise in der ersten Öffnung bzw. in der zweiten Öffnung aufgenommen sind.

2. Optischer Leser gemäß Anspruch 1, wobei jede Öffnung ein rechteckiger Ausschnitt ist, und wobei jeder der ersten und zweiten Spiegel (172, 174) ein rechteckiger, planarer Spiegel ist.

3. Optischer Leser gemäß Anspruch 1, wobei der Träger ein zweites planares Basissubstrat umfasst, auf dem ein stationärer Faltspiegel (182) getragen ist, und wobei der stationäre Spiegel (182) entlang des optischen Pfads zwischen den ersten und zweiten Spiegeln (172, 174) angeordnet ist.

4. Optischer Leser gemäß Anspruch 3, wobei die Lichtquelle eine Vertikaloberflächenhohlraum-emittierende Laserdiode (178) ist zum Emittieren des Lichtstrahls als ein einziger Laserstrahl.

5. Optischer Leser gemäß Anspruch 3, wobei die Lichtquelle eine Anordnung von Vertikalhohlraumoberflächen-emittierenden Laserdioden (166) ist zum Emittieren des Lichtstrahls als eine Vielzahl von Laserstrahlen.

6. Optischer Leser gemäß Anspruch 4, der ferner ein optisches Element (180) zum Fokussieren und Umlenken des Laserstrahls aufweist.

7. Optischer Leser gemäß Anspruch 5, der ferner eine schaltbare Anordnung (164) von optischen Elementen zum Fokussieren und Umlenken jedes Laserstrahls aufweist.

8. Optischer Leser gemäß Anspruch 1, der ferner ein Gehäuse (2, 4) mit einem Fenster (1, 3) aufweist, durch das der Lichtstrahl auf dem Weg zu den (Kenn-)Zeichen hindurchgeht.

## Revendications

1. Lecteur optique ayant une source de lumière pour émettre un faisceau lumineux (184) le long d'un chemin optique vers des signes codés devant être lus optiquement, et un dispositif de balayage pour animer le faisceau lumineux (184) d'un mouvement de balayage dans des directions mutuellement orthogonales sur les signes codés, le lecteur optique comprenant :
a) un support commun (176 ; 180, 181) ; et
b) le dispositif de balayage ayant un premier miroir pouvant être mis en oscillation (172 ; 191) monté sur le support pour osciller par rapport à celui-ci et animer le faisceau (184) d'un mouvement de balayage dans l'une des directions lorsqu'il est mis en oscillation, et un second miroir pouvant être mis en oscillation (174 ; 187) monté sur le support pour osciller par rapport à celui-ci afin d'animer le faisceau réfléchi par le premier miroir pouvant être mis en oscillation (172 ; 191) d'un mouvement de balayage dans l'autre des directions lorsqu'il est mis en oscillation, lesdits miroirs (172, 174 ; 187, 191) étant agencés sur le support selon un alignement optique mutuel le long du chemin optique du fait de leurs montages en des positions fixes sur le support ; **caractérisé en ce que** :
le support commun est un substrat de base plan (176) ayant des première et seconde ouvertures le traversant, et dans lequel les premier et second miroirs (172, 174) sont respectivement au moins partiellement reçus dans les première et seconde ouvertures.

2. Lecteur optique selon la revendication 1, dans lequel chaque ouverture est un découpage rectangulaire et dans lequel chacun des premier et second miroirs (172, 174) est un miroir rectangulaire plan.

3. Lecteur optique selon la revendication 1, dans lequel le support comporte un second substrat de base plan sur lequel prend appui un miroir de repliement stationnaire (182), et dans lequel le miroir stationnaire (182) est situé sur le chemin optique entre les premier et second miroirs (172, 174)

4. Lecteur optique selon la revendication 3, dans lequel la source de lumière est une diode laser à émission de surface à cavité verticale (178) pour émettre le faisceau lumineux sous la forme d'un faisceau laser unique.

5. Lecteur optique selon la revendication 3, dans lequel la source de lumière est un groupement de diodes laser à émission de surface à cavité verticale (166) pour émettre le faisceau lumineux sous la forme d'une pluralité de faisceaux laser.

6. Lecteur optique selon la revendication 4, comprenant en outre un élément optique (180) pour focaliser et dévier le faisceau laser.

7. Lecteur optique selon la revendication 5, comprenant en outre un groupement commutable (164) d'éléments optiques pour focaliser et dévier chaque faisceau laser.

8. Lecteur optique selon la revendication 1, comprenant en outre un boîtier (2, 4) ayant une fenêtre (1, 3) à travers laquelle passe le faisceau lumineux se propageant vers les signes.
